# EUROPEAN PATENT APPLICATION

(11) **EP 3 280 011 A1**
(43) Date of publication of application: **07.02.2018**
(21) Application number: 16182269.7
(22) Date of filing: 01.08.2016
(51) Int. Cl.: H01S 5/00, H01S 5/10, H01S 5/40, H04J 14/02, G02B 6/293

(54) **INTEGRATED MODE LOCKED LASER CHANNELS SELECTOR**

(71) Applicant: ALCATEL LUCENT, 92100 Boulogne-Billancourt (FR)
(72) Inventor: LELARGE, François, 91767 PALAISEAU (FR); CHIMOT, Nicolas, 92290 CHATENAY MALABRY (FR)
(74) Representative: Novagraaf Technologies

(57) **Abstract**

The present invention relates to an integrated apparatus (23) for selecting Mode Locked Laser (MLL) channels comprising a plurality of ring resonators (3), each ring resonator (3) comprising an input port (9) and a through port (11) characterised in that, at least one said ring resonator further comprises a drop port (19) and has a resonator frequency associated with an unwanted laser channel frequency, said drop port (19) being connected to an absorbing area (21) for reducing the unwanted laser channel power.

The invention also relates to a data transceiver (25) comprising a Mode Locked Laser (MLL) (1) an integrated apparatus (23) and a Semiconductor Optical Amplifier (SOA) (5).

## Description

### Field of the Invention

The present invention relates to data transceivers more particularly to an integrated mode locked laser channels selector.

### Background

With growing demand in data centers, higher data throughput transceivers are required. Wavelength Division Multiplex (WDM) based transceivers have moved into the spotlight for these applications. Indeed, the increase of channel count as part of C-Form Factor Pluggable (CFP) roadmap remains attractive compared to parallel optics despite the additional complexity associated with the current implementation of a WDM system. The development of 100G, 200G and 400G sources based on respectively 4x25Gb/s, 8x25Gb/s and 16x25Gb/s on-off keying (OOK) is currently a really hot research topic implying huge sources.

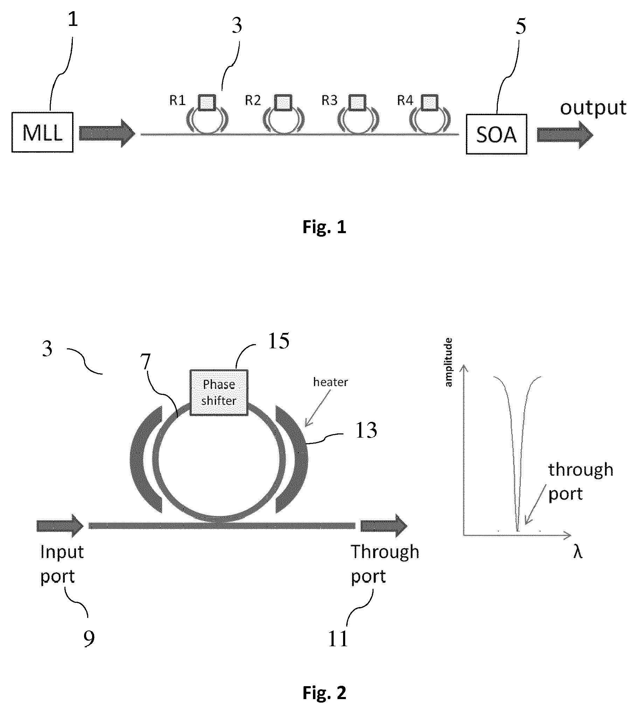

These sources can be based on the combination of a Mode-Locked-Lasers (MLL) and Ring Resonator Modulators (RRM) (see [R1] and Figure 1). The MLL is used to generate a comb of channels and constitutes a really attractive solution since it can be compact and enables to reduce the cost due to the reduction of the numbers of sources required. For instance, single-section MLL relying on non-linear optical effects provide high total optical output power and enable to achieve stable Free Spectral Range (FSR) between the channels easing the matching with standardized WDM grid (see [R2]).

The number of channels in the comb and their power depend on the FSR; the larger they are, the lower the optical power per mode is. However, for instance, in the case of the 4x25Gb/s sources, only 4 channels are useful. Keeping the other ones may be an issue for the device and degrade the quality of data transmission. Indeed, it is usually necessary to use a Semiconductor Optical Amplifier (SOA) to re-amplify the optical power per mode which can be even reduced through flip-chip assembly (see [R1]). However, the SOA must operate in its linear range which means that it should not be saturated by entering optical power. Consequently, unwanted channels may be detrimental since they participate to the SOA saturation and suck down useful amplification initially available for the 4 selected channels. Besides, these unwanted channels would propagate along with the 4 selected channels through the transmission link without any reason.

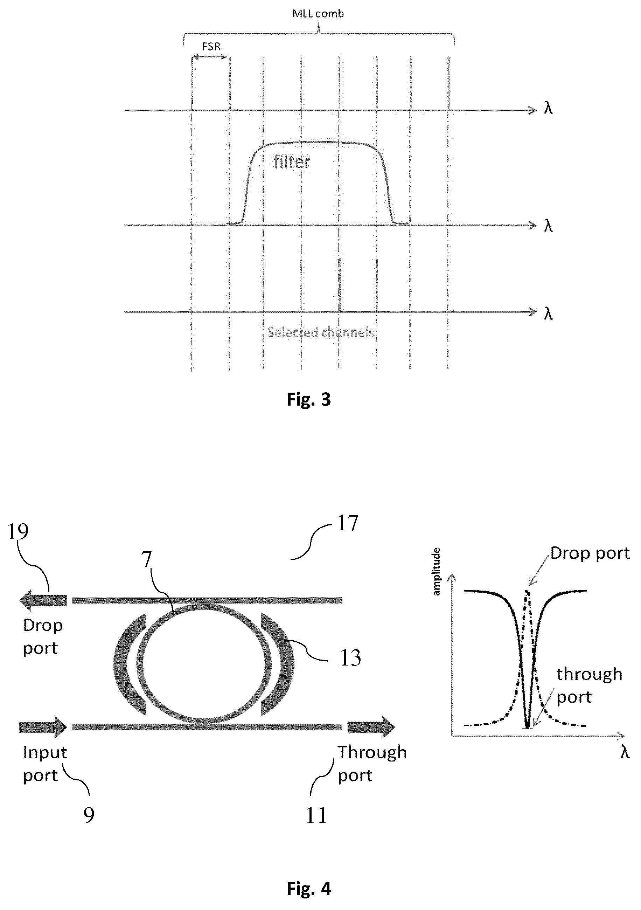

The standard solution to select 4 channels is to use a filter with an appropriate bandpass, larger than 4 x FSR (Figure 3). This filter can be placed before the cascaded RRM. However, the main drawbacks of this configuration are that filter insertions losses are added to the system and only channels in a row can be isolated, limiting the flexibility. Moreover, the larger the number of channels is, the larger the bandpass has to be, and the more complex and lossy the filter is.

### Summary

The present invention proposes a key emitter components to address the needs of low cost WDM sources for data centers and solve the prior art drawbacks.

First, it proposes an integrated mode locked laser channels selector enabling to remove unwanted laser channels and to prevent the SOA from being saturated when it is used in a data transceiver. Moreover, it enables to add/remove channels to dynamically change the data throughput.

Secondly, it proposes a data transceiver equipped with the integrated mode locked laser channels selector.

In a first embodiment, an integrated apparatus for selecting mode locked laser channels comprising a plurality of ring resonators, each ring resonator comprising an input port and a through port characterised in that, at least one said ring resonator further comprises a drop port and has a resonator frequency associated with an unwanted laser channel frequency, said drop port being connected to an absorbing area for reducing the unwanted laser channel power.

Advantageously, the integrated apparatus allows said at least one ring resonator to be also associated with on-off keyings, which respectively can activate the drop port while desactivating the through port or desactivate the drop port while activating the through port.

This embodiment may comprises other features, alone or in combination, such as:
- said on-off keyings are made by phase shifters;
- the ring resonators comprise local heater adapted to accurately match the channel wavelength with a resonance of the ring.

The present invention further relates to a data transceiver comprising a Mode Locked Laser (MLL), an integrated apparatus of one of the claim 1 to 4 and a Semiconductor Optical Amplifier (SOA) wherein the MLL generates a comb of channels, and the channels can be selected by sending them to the through port of one or to the drop port of at least one ring resonator, preventing the SOA from being saturated

The data transceiver may further comprise four simple ring resonators and four ring resonators equipped with a drop port connected to absorbing areas for reducing the unwanted laser channels' power.

### Brief Description of the Drawings

Some embodiments of apparatus in accordance with embodiments of the present invention are now described, by way of example only, and with reference to the accompagnying drawings, in which :
- The Figure 1 schematically illustrates a current transceiver based on a Mode-Locked-Lasers (MLL) and four Ring Resonator Modulators (RRM).
- The Figure 2 schematically illustrates a RRM and its spectral characteristic;
- The Figure 3 schematically illustrates how the current transceiver of Figure 1 works spectrally;
- The Figure 4 schematically illustrates an embodiment of the present invention comprising four RRM and Through-Drop Ring Resonator Modulators (TD-RRM) integrated in a transceiver;
- The Figure 5 schematically illustrates a TD-RRM and its spectral characteristic;
- The Figure 6 schematically illustrates how the transceiver of Figure 4 spectrally works ;
- The Figure 7 schematically illustrates another embodiment of the invention ; and
- The Figure 8 schematically illustrates how the transceiver of Figure 4 can works spectrally depending on the setting.

### Description of Embodiments

The following examples will focused on a 4x25Gb/s transceiver but can be easily generalized.

Figure 1 describes a data transceiver structure, currently used by persons skilled in the art. It is composed of a Mode-Locked-Lasers (MLL) 1, four Ring Resonator Modulators (RRM) 3 and a Semiconductor Optical Amplifier (SOA) 5 (see [R1]).

The MLL 1 is used to generate a comb of channels. For instance, single-section MLL relying on non-linear optical effects provide high total optical output power and enable to achieve stable Free Spectral Range (FSR) between the channels easing the matching with standardized WDM grid (see [R2]). The RRM 3 are cascaded along a single waveguide connected to the MLL 1 and each one is selective to one channel.

A type of RRM 3 is shown in Figure 2. It comprises a ring 7, an input port 9 and a through port 11 and is associated here with:
- a local heater 13, that can be used to accurately match the channel wavelength with a resonance of the ring; and
- a phase shifter 15 which can perform the OOK modulation.

Figure 2 also describes schematically the spectral characteritic of the signal outgoing the through port.

To understand the way it works, Figure 3 shows its spectral characteristics of Figure 1 data transceiver comprising a filter (not represented on Figure 1) with an appropriate bandpass adapted to select 4 channels.

The MLL 1 generates a comb with 8 channels (top graph). The filter can be placed before the cascaded RRM 3 and it selects the channels comprised in its bandpass (see middle and bottom graphs).

However, as described before, the main drawbacks of this configuration are that filter insertions losses are added to the system and only channels in a row can be isolated, limiting the flexibility. Moreover, the larger the number of channels is, the larger the bandpass has to be, and the more complex and lossy the filter is.

The present invention consists in using at least on Through-Drop Ring Resonator Modulator (TD-RRM) 17 as described in Figure 4 combined with an absorbing area 21 (not represented in this figure).

The TD-RRM 17 is a RRM 3 comprising a resonator frequency associated with an unwanted laser channel frequency and a drop port 19 connected to an absorbing area 21 adapted to reduce the unwanted laser channel power.

It is associated here with a local heater 13, that can be used to accurately match the channel wavelength with the unwanted laser channel resonance of the ring 7.

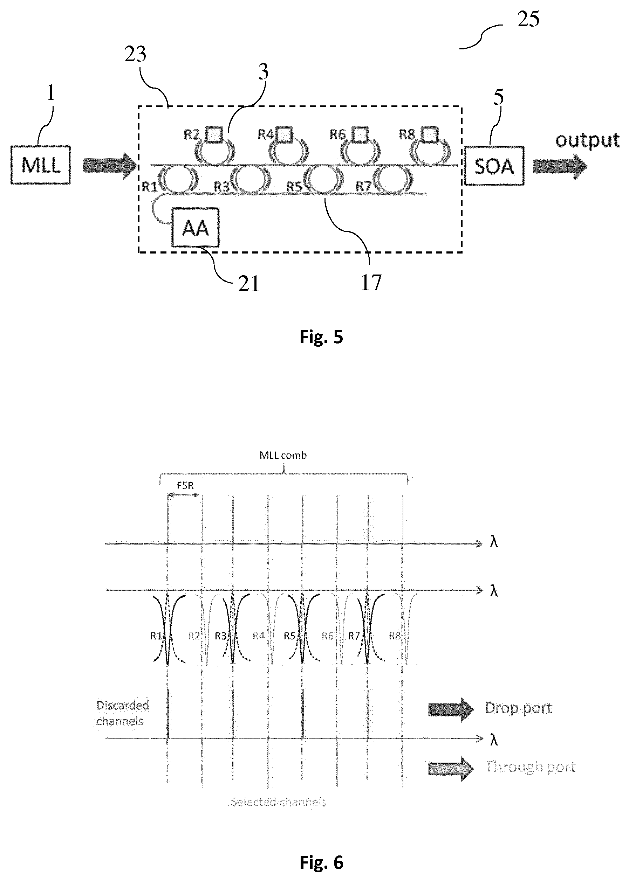

An embodiment of the invention is described in Figure 5.

In this embodiment, the integrated apparatus 23 is composed of eight ring resonators (RR) cascaded, four of which are RRM 3 to modulate the four used channels and four of which are TD-RRM 17 to catch unwanted channels and send the power into an absorbing area 21 connected to the drop port 19.

Figure 6 explains the principle of the present embodiment.

The top graph shows a comb of 8 channels generated by the MLL 1, before entering into the cascaded RR network.

The middle graph shows the spectral characteristics from the four RRM 3 and the four TD-RRM 17. It can be noticed that the detuning of each ring resonance with respect to its correspondent channel is different whether the ring is a RRM 3 or a TD-RRM 17. The detuning can be locally adjusted with a heater 13. In the case of RRM 3 (rings R2, R4, R6 and R8), the detuning is adjusted so as to perform regular OOK. In the case of TD-RR 17 (rings R1, R3, R5 and R7), the resonance is tuned so as to maximize the power sent into the drop port 19.

The bottom graph shows the resulted four discarded and four selected channels.

It can be noticed that the four RRM 3 as sketched in Figure 6 can be in a different order, since the resonance wavelengths mismatches with unwanted channels to be removed can be compensated with local heaters. The same reasoning can be made for the four TD-RRM 17.

A phase shifter 15 can be embedded into the TD-RRM 17 so as to use them in case of need as additional OOK modulators by sending the power into the through port using the same detuning as for the RRM R2, R4, R6 and R8. The OOK works like a sort of switch, when it sends the resonance channel frequency to the through port it disables the drop port and vice versa, when the resonance channel frequency is a unwanted channel, the OOK sends it to the drop port while disabling the through port.

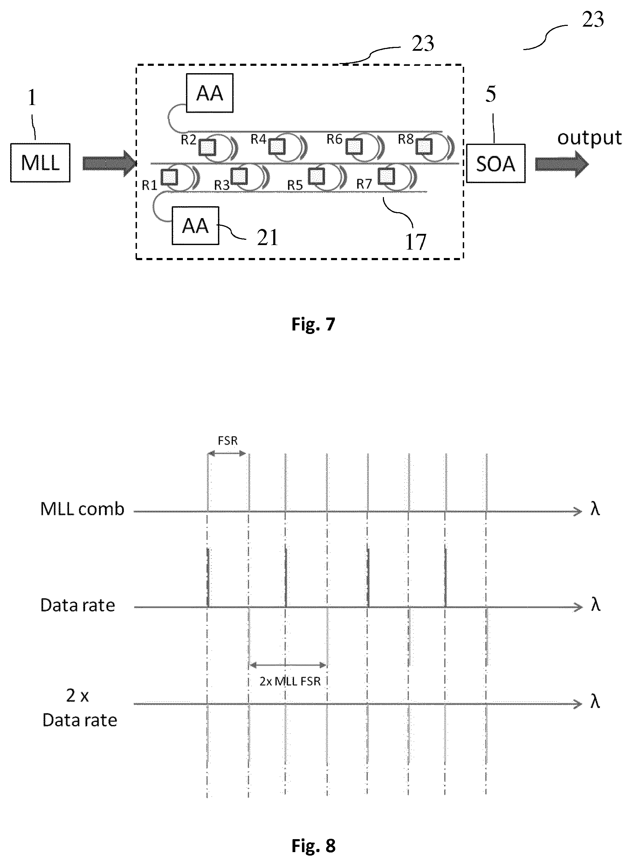

Figure 7 shows another embodiment of the present invention, where the integrated apparatus 23 is only composed of TD-RRM 17.

Advantageouly, the TD-RRM are endowed with phase shifters 15 enabling to add or cancel channels according to the needs (in terms of wavelength allocation for instance) within the whole MLL comb.

Moreover, the TD-RRM 17 can endow heaters 13 to accurately match the channel wavelength with a resonance of the ring.

An important difference with respect to the solution depicted in Figure 1 and the filter solution is that selected channels don't necessarily have to be in a row. In addition, it easily enables to interleave channels to increase data throughput if necessary as shown Figure 8.

The top graph of Figure 8 shows a comb of 8 channels generated by the MLL 1, before entering into the cascaded RR network.

The middle graph shows the spectral characteristics when such embodiment is used in configuration of Figure 6.

Finally, the bottom graph shows the spectral characteristics when all the channels are selected.

The invention also relates to a data transceiver 25 comprising a MLL 1, an integrated apparatus 23 as previously described and a SOA 5. The two examples of embodiment for the integrated apparatus can be used for a 4x25Gb/s date transceiver 25 but its structure can be easily generalized to N rings cascaded in order to reach other efficient data throughput (for example 8x25Gb/s or 16x25Gb/s).

The invention has many advantages. It offers a high flexibility and an innovative solution for datacenter, it lowers insertion losses and it prevents from saturating the SOA. It is easy and low cost to produce.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

### REFERENCES LIST

- [R1]: J. Witzens & al., Photonic West, 9368-22 (2015)
- [R2]: G.G. Duan & al., Bell Labs Technical Journal 14(3), p. 63-94 (2009)

## Claims

1. An integrated apparatus (23) for selecting mode locked laser channels comprising a plurality of ring resonators (3), each ring resonator (3) comprising an input port (9) and a through port (11) **characterised in that**, at least one said ring resonator (3) further comprises a drop port (19) and has a resonator frequency associated with an unwanted laser channel frequency, said drop port (19) being connected to an absorbing area (21) for reducing the unwanted laser channel power.

2. The apparatus (23) of claim 1, wherein said at least one ring resonator (3) is also associated with on-off keyings (, which respectively can activate the drop port (19) while desactivating the through port (11) or desactivate the drop port (19) while activating the through port (11).

3. The apparatus (23) of claim 2, wherein said on-off keyings are made by phase shifters (15).

4. The apparatus (23) of one of the claims 1 to 3, wherein the ring resonators (3) comprise local heater (13) adapted to accurately match the channel wavelength with a resonance of the ring.

5. A data transceiver (25) comprising a Mode Locked Laser (MLL) (1), an integrated apparatus (23) of one of the claim 1 to 4 and a Semiconductor Optical Amplifier (SOA) (5) wherein the MLL (1) generates a comb of channels, and the channels can be selected by sending them to the through port (11) or to the drop port (19) of at least one ring resonator (3), preventing the SOA (5) from being saturated.

6. The data transceiver (25) of claim 5 comprising four simple ring resonators (3) and four ring resonators (3) equipped with a drop port (19) connected to absorbing areas (21) for reducing the unwanted laser channels' power.
